# EUROPEAN PATENT APPLICATION

(11) **EP 4 823 249 A1**
(43) Date of publication of application: **14.10.2026**
(21) Application number: 24922429.6
(22) Date of filing: 05.12.2024
(51) Int. Cl.: H05K 1/11, H05K 1/02, H05K 5/06, H04M 1/03, H04M 1/02

(54) **ELECTRONIC DEVICE COMPRISING PRINTED CIRCUIT BOARD HAVING FILL-CUT PART**

(30) Priority: 31.01.2024 KR 20240015461; 07.02.2024 KR 20240019263
(71) Applicant: Samsung Electronics Co., Ltd., Suwon-si, Gyeonggi-do 16677 (KR)
(72) Inventor: LEE, Seunghyuk, Suwon-si, Gyeonggi-do 16677 (KR); YUN, Cheongno, Suwon-si, Gyeonggi-do 16677 (KR); LEE, Sangjun, Suwon-si, Gyeonggi-do 16677 (KR); LEE, Soojung, Suwon-si, Gyeonggi-do 16677 (KR); LEE, Wonsun, Suwon-si, Gyeonggi-do 16677 (KR); LEE, Pyeonghee, Suwon-si, Gyeonggi-do 16677 (KR); JUNG, Dongkeun, Suwon-si, Gyeonggi-do 16677 (KR)
(74) Representative: Gulde & Partner
(86) International application number: PCT/KR2024/019889
(87) International publication number: WO 2025/164920

(57) **Abstract**

This electronic device comprises: a housing; a camera in the housing, arranged at the edge of the electronic device; a speaker arranged beside the camera; and a PCB including an opening part in which the speaker is accommodated, and a neck end part between the speaker and the camera, wherein the PCB includes a plurality of non-conductive layers, a conductive pad arranged at one from among outer layers of the plurality of non-conductive layers, and conductive patterns arranged between the non-conductive layers, a part of the conductive pad having arranged at the neck end part and the conductive patterns being disconnected from the neck end part by a predetermined distance.

## Description

### [Technical Field]

The present disclosure relates to an electronic device including a printed circuit board having a fill-cut portion.

### [Background Art]

As an electronic device become smaller and thinner, restrictions may be imposed on a thickness and a size of components disposed in the electronic device. For miniaturization of the electronic device, it may be required to reduce a size of individual electronic components and optimize a disposition structure. It may be required to provide a structure for reducing noise caused by electromagnetic interference between the electronic components while optimizing the disposition structure.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

An electronic device according to an embodiment is disclosed. The electronic device may include a housing. The electronic device may further include a camera. The camera may be positioned in the housing and disposed at an edge of the electronic device. The electronic device may further include a speaker. The electronic device may be disposed adjacent to the camera. The electronic device may further include a printed circuit board. The printed circuit board may include an opening in which the speaker is accommodated, and a neck portion between the speaker and the camera. The printed circuit board may include a plurality of non-conductive layers. The printed circuit board may further include a conductive pad. The conductive pad may be disposed on one outer layer among outer layers of the plurality of non-conductive layers. The printed circuit board may further include conductive patterns. The conductive patterns may be disposed between the non-conductive layers. A portion of the conductive pad may be disposed on the neck portion, and the conductive patterns may be disconnected at a predetermined distance at the neck portion.

An electronic device according to an embodiment is disclosed. The electronic device may include a first electronic component. The electronic device may further include a second electronic component. The second electronic component may be disposed adjacent to the first electronic component. The electronic device may further include a printed circuit board. The printed circuit board may include an opening in which the first electronic component is accommodated, and a neck portion between the first electronic component and the second electronic component. The neck portion may include a plurality of non-conductive layers stacked sequentially. The neck portion may further include a conductive pad on one outer layer among outer layers of the plurality of non-conductive layers. The printed circuit board may include conductive patterns disconnected at a predetermined distance at the neck portion.

### [Description of the Drawings]

FIG. 1 is a diagram illustrating an electronic device according to an embodiment.
FIG. 2 is an exploded perspective view of an electronic device according to an embodiment.
FIG. 3 is a diagram illustrating an interior of an exemplary electronic device.
FIG. 4A is a cross-sectional view of an exemplary electronic device.
FIG. 4B is a cross-sectional view of a printed circuit board of an exemplary electronic device.
FIGS. 5A, 5B, 5C, 5D, and 5E are diagrams exemplarily illustrating disposition of a fill-cut portion of a printed circuit board.
FIG. 6A exemplarily illustrates a current path and a magnetic field caused by current around a speaker, which is disposed on a printed circuit board not including a fill-cut portion.
FIG. 6B exemplarily illustrates a current path and a magnetic field caused by current around a speaker, which is disposed on a printed circuit board including a fill-cut portion.
FIG. 7 exemplarily illustrates magnitude of noise transmitted to a speaker disposed on a printed circuit board including a fill-cut portion.
FIG. 8 is a block diagram of an electronic device in a network environment according to various embodiments.

### [Mode for Invention]

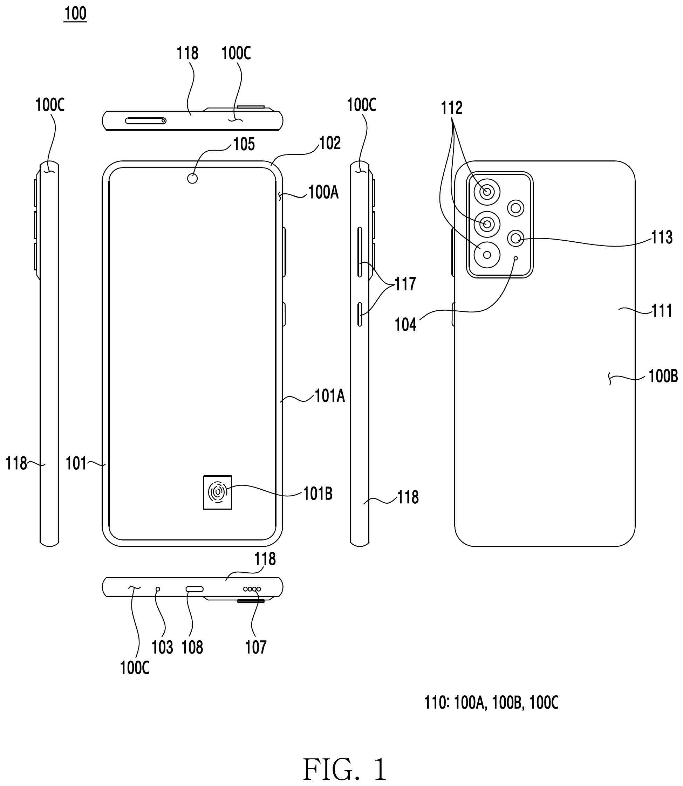

FIG. 1 is a diagram illustrating an electronic device according to an embodiment.

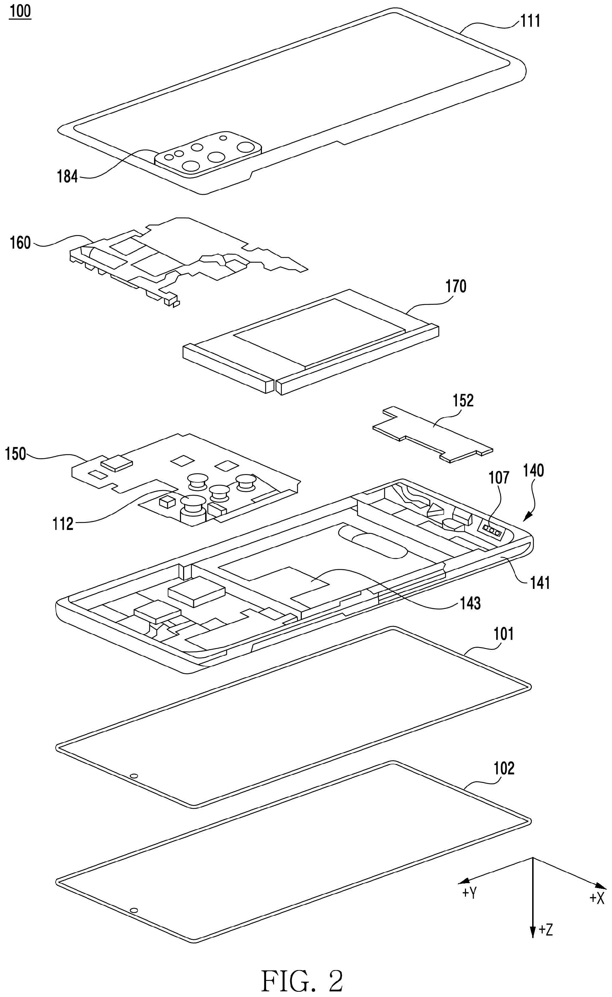

Referring to FIG. 1, an electronic device 100 according to an embodiment may include a housing 110 forming an exterior of the electronic device 100. For example, the housing 110 may include a first surface (or front surface) 100A, a second surface (or rear surface) 100B, and a third surface (or lateral surface) 100C surrounding a space between the first surface 100A and the second surface 100B. In an embodiment, the housing 110 may refer to a structure (e.g., a frame structure 140 of FIG. 2) forming at least a portion of the first surface 100A, the second surface 100B, and/or the third surface 100C.

The electronic device 100 according to an embodiment may include a substantially transparent front plate 102. In an embodiment, the front plate 102 may form at least a portion of the first surface 100A. In an embodiment, the front plate 102 may include, for example, a glass plate or a polymer plate that includes various coating layers, but is not limited thereto.

The electronic device 100 according to an embodiment may include a substantially opaque rear plate 111. In an embodiment, the rear plate 111 may form at least a portion of the second surface 100B. In an embodiment, the rear plate 111 may be formed by coated or colored glass, ceramic, polymer, metal (e.g., aluminum, stainless steel (STS), or magnesium), or a combination of at least two of the materials.

The electronic device 100 according to an embodiment may include a side bezel structure (or side member) 118 (e.g., a side wall 141 of the frame structure 140 of FIG. 2). In an embodiment, the side bezel structure 118 may form at least a portion of the third surface 100C of the electronic device 100 by being coupled with the front plate 102 and/or the rear plate 111. For example, the side bezel structure 118 may form the entire third surface 100C of the electronic device 100, and for another example, the side bezel structure 118 may form the third surface 100C of the electronic device 100 together with the front plate 102 and/or the rear plate 111.

Unlike the illustrated embodiment, in a case that the third surface 100C of the electronic device 100 is partially formed by the front plate 102 and/or the rear plate 111, the front plate 102 and/or the rear plate 111 may include a region that is bent toward the rear plate 111 and/or the front plate 102 at its edge and seamlessly extends. For example, the extending region of the front plate 102 and/or the rear plate 111 may be positioned at both ends of a long edge of the electronic device 100, but is not limited by the above-described example.

In an embodiment, the side bezel structure 118 may include metal and/or polymer. In an embodiment, the rear plate 111 and the side bezel structure 118 may be integrally formed and may include the same material (e.g., a metallic material such as aluminum), but are not limited thereto. For example, the rear plate 111 and the side bezel structure 118 may be formed in separate configurations and/or may include different materials.

In an embodiment, the electronic device 100 may include at least one of a display 101, an audio modules 103, 104, and 107, a sensor module (not illustrated), camera modules 105, 112, and 113, a key input device 117, a light emitting element (not illustrated), and/or a connector hole. In an embodiment, the electronic device 100 may omit at least one of the components (e.g., the key input device 117 or the light emitting element (not illustrated)), or may additionally include another component.

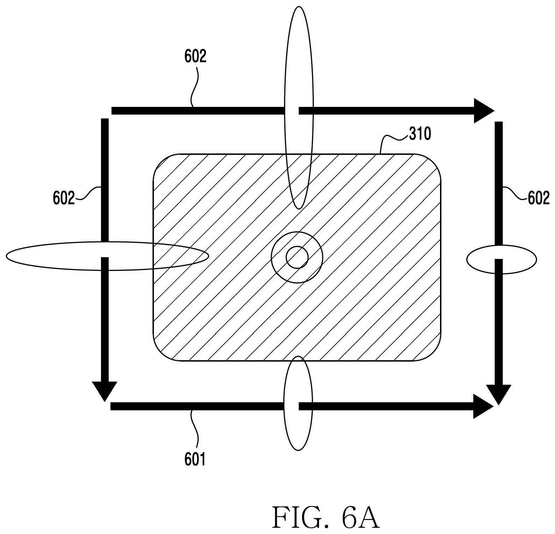

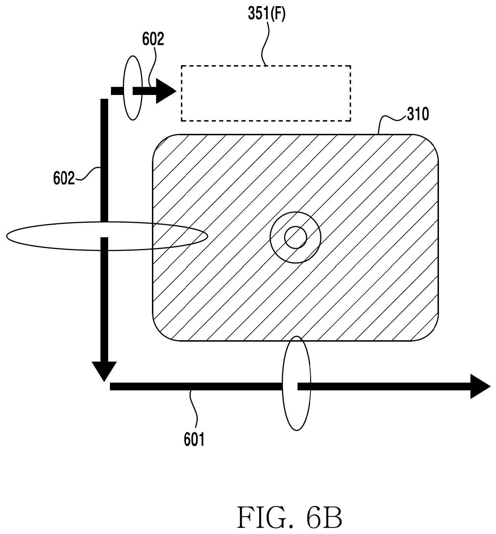

In an embodiment, the display 101 (e.g., a display module 660 of FIG. 6) may be visually exposed through a significant portion of the front plate 102. For example, at least a portion of the display 101 may be visible through the front plate 102 forming the first surface 100A. In an embodiment, the display 101 may be disposed on a back surface of the front plate 102.

In an embodiment, an outer shape of the display 101 may be formed substantially the same as an outer shape of the front plate 102 adjacent to the display 101. In an embodiment, in order to expand an area in which the display 101 is visually exposed, a gap between an outer periphery of the display 101 and an outer periphery of the front plate 102 may be formed substantially the same.

In an embodiment, the display 101 (or the first surface 100A of the electronic device 100) may include a screen display region 101A. In an embodiment, the display 101 may provide a user with visual information through the screen display region 101A. In the illustrated embodiment, when the first surface 100A is viewed from the front, the screen display region 101A is illustrated as being spaced apart from an outer periphery of the first surface 100A and positioned inside the first surface 100A, but it is not limited thereto. In an embodiment, when the first surface 100A is viewed from the front, at least a portion of an edge of the screen display region 101A may substantially coincide with an edge of the first surface 100A (or the front plate 102).

In an embodiment, the screen display region 101A may include a sensing region 101B configured to obtain biometric information of the user. Herein, a meaning of "the screen display region 101A including the sensing region 101B" may be understood as that at least a portion of the sensing region 101B may be overlapped with the screen display region 101A. For example, the sensing region 101B may mean a region capable of displaying visual information by the display 101 like another region of the screen display region 101A, and additionally obtaining biometric information (e.g., a fingerprint) of the user. In an embodiment, the sensing region 101B may be formed in the key input device 117.

In an embodiment, the display 101 may include a region in which the first camera module 105 (e.g., a camera module 680 of FIG. 6) is positioned. In an embodiment, an opening is formed in the region of the display 101, and the first camera module 105 (e.g., a punch hole camera) may be at least partially disposed in the opening to face the first surface 100A. In this case, the screen display region 101A may cover at least a portion of an edge of the opening. In an embodiment, the first camera module 105 (e.g., an under display camera (UDC)) may be disposed under the display 101 to overlap the region of the display 101. In this case, the display 101 may provide the user with visual information through the region, and additionally, the first camera module 105 may obtain an image corresponding to a direction toward the first surface 100A through the region of the display 101.

In an embodiment, the display 101 may be coupled with or disposed adjacent to touch sensing circuitry, a pressure sensor capable of measuring an intensity (pressure) of a touch, and/or a digitizer that detects a magnetic field type stylus pen.

In an embodiment, the audio modules 103, 104, and 107 (e.g., an audio module 670 of FIG. 6) may include microphone holes 103 and 104 and a speaker hole 107.

In an embodiment, the microphone holes 103 and 104 may include a first microphone hole 103 formed in a partial region of the third surface 100C and a second microphone hole 104 formed in a partial region of the second surface 100B. A microphone (not illustrated) for obtaining an external sound may be disposed in the microphone holes 103 and 104. The microphone may include a plurality of microphones to sense a direction of sound.

In an embodiment, the second microphone hole 104 formed in a partial region of the second surface 100B may be disposed to be adjacent to the camera modules 105, 112, and 113. For example, the second microphone hole 104 may obtain sound according to an operation of the camera modules 105, 112, and 113. However, it is not limited thereto.

In an embodiment, the speaker hole 107 may include an external speaker hole 107 and a call receiver hole (not illustrated). The external speaker hole 107 may be formed in a portion of the third surface 100C of the electronic device 100. In an embodiment, the external speaker hole 107 may be implemented as one hole with the microphone hole 103. Although not illustrated, the call receiver hole (not illustrated) may be formed in another portion of the third surface 100C. For example, the call receiver hole may be formed in an opposite side of the external speaker hole 107 on the third surface 100C. For example, with respect to the illustration of FIG. 1, the external speaker hole 107 may be formed on the third surface 100C corresponding to a lower end portion of the electronic device 100, and the call receiver hole may be formed on the third surface 100C corresponding to an upper end portion of the electronic device 100. However, it is not limited thereto, and in an embodiment, the call receiver hole may be formed at a position other than the third surface 100C. For example, the call receiver hole may be formed by a separated space between the front plate 102 (or the display 101) and the side bezel structure 118.

In an embodiment, the electronic device 100 may include at least one speaker (not illustrated) configured to output sound to the outside of the housing 110 through the external speaker hole 107 and/or the call receiver hole (not illustrated).

In an embodiment, the sensor module (not illustrated) (e.g., a sensor module 676 of FIG. 6) may generate an electrical signal or a data value corresponding to an operating state inside the electronic device 100 or an external environmental state . For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 105, 112, and 113 (e.g., the camera module 680 of FIG. 6) may include the first camera module 105 disposed to face the first surface 100A of the electronic device 100, a second camera module 112 disposed to face the second surface 100B, and a flash 113.

In an embodiment, the second camera module 112 may include a plurality of cameras (e.g., a dual camera, a triple camera, or a quad camera). However, the second camera module 112 is not necessarily limited to including the plurality of cameras, and may include one camera.

In an embodiment, the first camera module 105 and the second camera module 112 may include one or a plurality of lenses, an image sensor, and/or an image signal processor.

In an embodiment, the flash 113 may include, for example, a light emitting diode or a xenon lamp. In an embodiment, two or more lenses (an infrared camera, a wide-angle and telephoto lens) and image sensors may be disposed on a surface of the electronic device 100.

In an embodiment, the key input device 117 (e.g., an input module 650 of FIG. 6) may be disposed on the third surface 100C of the electronic device 100. In an embodiment, the electronic device 100 may not include a portion or all of the key input device 117, and the key input device 117, which is not included, may be implemented in another form, such as a soft key, on the display 101.

In an embodiment, the connector hole may be formed on the third surface 100C of the electronic device 100 such that a connector of an external device may be accommodated. A connecting terminal (e.g., a connecting terminal 678 of FIG. 6) electrically connected to a connector of an external device may be disposed in the connector hole. The electronic device 100 according to an embodiment may include an interface module (e.g., an interface 677 of FIG. 6) for processing an electrical signal transmitted and received through the connecting terminal.

In an embodiment, the electronic device 100 may include the light emitting element (not illustrated). For example, the light emitting element (not illustrated) may be disposed on the first surface 100A of the housing 110. The light emitting element (not illustrated) may provide state information of the electronic device 100 in an optical form. In an embodiment, the light emitting element (not illustrated) may provide a light source linked with an operation of the first camera module 105. For example, the light emitting element (not illustrated) may include an LED, an IR LED, and/or a xenon lamp.

FIG. 2 is an exploded perspective view of an electronic device according to an embodiment.

Hereinafter, overlapping description of a configuration having the same reference numeral as the above-described configuration is omitted.

Referring to FIG. 2, an electronic device 100 according to an embodiment may include a frame structure 140, a first printed circuit board, a second printed circuit board 152, a cover plate 160, and a battery 170.

In an embodiment, the frame structure 140 may include a side wall 141 forming an exterior of the electronic device 100 (e.g., the third surface 100C of FIG. 2) and a support portion 143 extending inward from the side wall 141. In an embodiment, the frame structure 140 may be disposed between a display 101 and a rear plate 111. In an embodiment, the side wall 141 of the frame structure 140 may cover a space between the rear plate 111 and a front plate 102 (and/or the display 101), and the support portion 143 of the frame structure 140 may extend from the side wall 141 in the space. According to an embodiment, the side wall 141 forming a lateral surface (e.g., a lateral surface 100C of FIG. 2) of the electronic device 100 may include a speaker hole 107 connecting the inside and the outside of the electronic device 100. The speaker hole 107 may penetrate the side wall 141.

In an embodiment, the frame structure 140 may support or accommodate other components included in the electronic device 100. For example, the display 101 may be disposed on a surface of the frame structure 140 facing in a direction (e.g., a +z direction), and the display 101 may be supported by the support portion 143 of the frame structure 140. For another example, the first printed circuit board 150, the second printed circuit board 152, the battery 170, and a second camera module 112 may be disposed on another surface of the frame structure 140 facing in an opposite direction (e.g., a -z direction) to the direction. The first printed circuit board 150, the second printed circuit board 152, the battery 170, and the second camera module 112 may be seated in a recess defined by the side wall 141 and/or the support portion 143 of the frame structure 140, respectively.

In an embodiment, the first printed circuit board 150, the second printed circuit board 152, and the battery 170 may be coupled with the frame structure 140, respectively. For example, the first printed circuit board 150 and the second printed circuit board 152 may be fixedly disposed in the frame structure 140 through a coupling member such as a screw. For example, the battery 170 may be fixedly disposed in the frame structure 140 through an adhesive member (e.g., a double-sided tape). However, it is not limited by the above-described example.

In an embodiment, the cover plate 160 may be disposed between the first printed circuit board 150 and the rear plate 111. In an embodiment, the cover plate 160 may be disposed on the first printed circuit board 150. For example, the cover plate 160 may be disposed on a surface of the first printed circuit board 150 facing in the -z direction.

In an embodiment, the cover plate 160 may at least partially overlap the first printed circuit board 150 with respect to a z-axis. In an embodiment, the cover plate 160 may cover at least a partial region of the first printed circuit board 150. Through this, the cover plate 160 may protect the first printed circuit board 150 from a physical impact or prevent detachment of a connector coupled to the first printed circuit board 150.

In an embodiment, the cover plate 160 may be fixedly disposed on the first printed circuit board 150 through a coupling member (e.g., a screw), or may be coupled to the frame structure 140 together with the first printed circuit board 150 through the coupling member.

In an embodiment, the display 101 may be disposed between the frame structure 140 and the front plate 102. For example, the front plate 102 may be disposed on a side (e.g., in the +z direction) of the display 101, and the frame structure 140 may be disposed on another side (e.g., in the -z direction).

In an embodiment, the front plate 102 may be coupled with the display 101. For example, the front plate 102 and the display 101 may be bonded to each other through an optical adhesive member (e.g., an optically clear adhesive (OCA) or an optically clear resin (OCR)) interposed therebetween.

In an embodiment, the front plate 102 may be coupled with the frame structure 140. For example, the front plate 102 may include an outer portion extending outside the display 101 when viewed in a z-axis direction, and may be bonded to the frame structure 140 through an adhesive member (e.g., a double-sided tape) disposed between the outer portion of the front plate 102 and the frame structure 140 (e.g., the side wall 141). However, it is not limited by the above-described example.

In an embodiment, a processor (e.g., a processor 620 of FIG. 6), memory (e.g., a memory 630 of FIG. 6), and/or an interface (e.g., an interface 677 of FIG. 6) may be mounted on the first printed circuit board 150 and/or the second printed circuit board 152. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 100 to an external electronic device, and may include a USB connector, an SD card/MMC connector, or an audio connector. In an embodiment, the first printed circuit board 150 and the second printed circuit board 152 may be operatively or electrically connected to each other through a connection member (e.g., a flexible printed circuit board).

In an embodiment, the battery 170 (e.g., a battery 689 of FIG. 6) may supply power to at least one component of the electronic device 100. For example, the battery 170 may include a rechargeable secondary battery or a fuel cell. At least a portion of the battery 170 may be disposed on substantially the same plane as the first printed circuit board 150 and/or the second printed circuit board 152.

The electronic device 100 according to an embodiment may include an antenna module (not illustrated) (e.g., an antenna module 697 of FIG. 6). In an embodiment, the antenna module may be disposed between the rear plate 111 and the battery 170. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power to and from an external device.

In an embodiment, a housing 110 of the electronic device 100 may mean a configuration or a structure forming at least a portion of the exterior of the electronic device 100. In this regard, at least a portion of the front plate 102, the frame structure 140, and/or the rear plate 111 forming the exterior of the electronic device 100 may be referred to as the housing 110 of the electronic device 100.

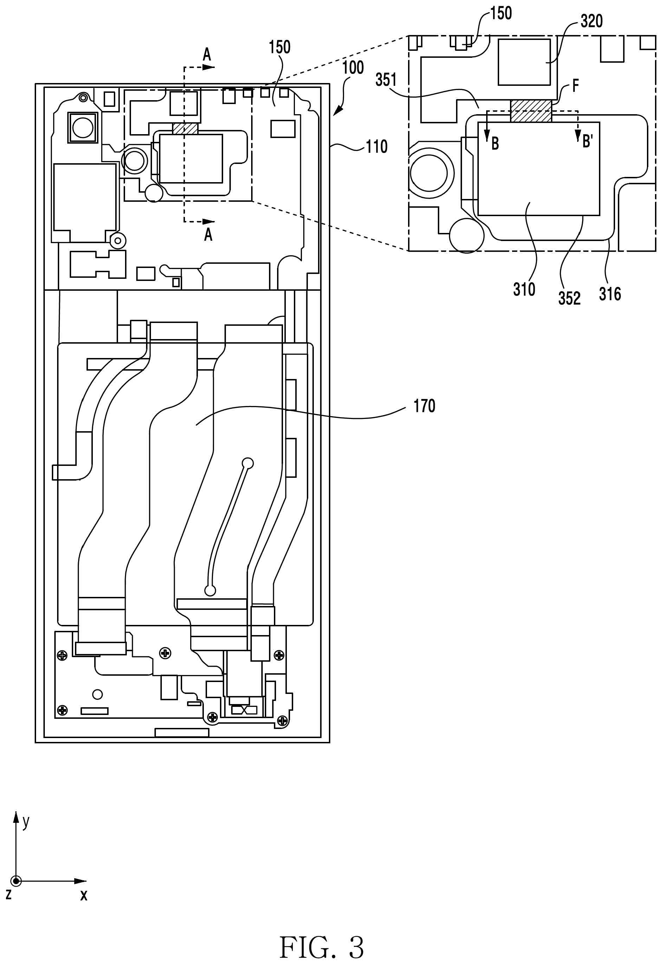

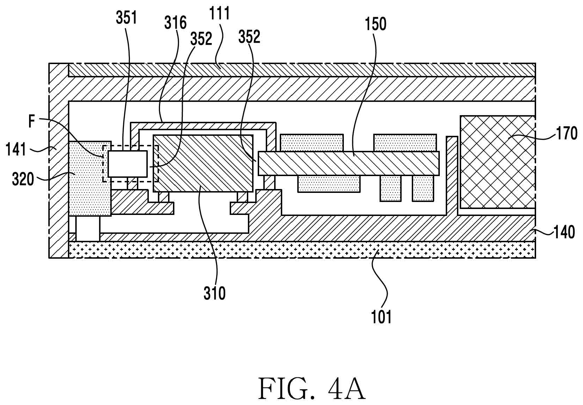

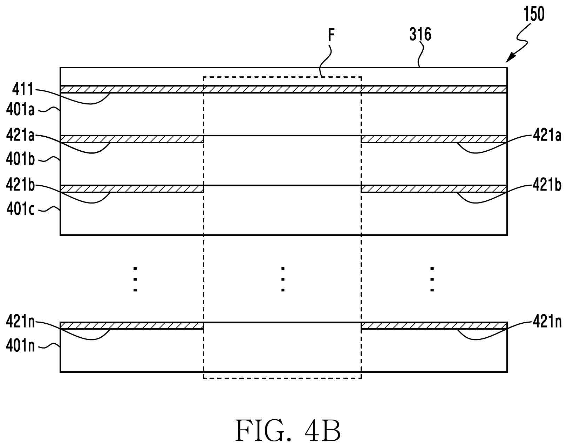

FIG. 3 is a diagram illustrating an interior of an exemplary electronic device. FIG. 4A is a cross-sectional view of an exemplary electronic device. FIG. 4B is a cross-sectional view of a printed circuit board of an exemplary electronic device.

Referring to FIGS. 3, 4A, and 4B, an electronic device 100 may include a printed circuit board 150, a speaker 310, a camera 320, and a battery 170 disposed on a frame structure 140 disposed in a housing 110. The electronic device 100 may refer to at least a portion of the electronic device 100 of FIG. 1 and the electronic device 100 of FIG. 2.

The electronic device 100 may include another printed circuit board spaced apart from the printed circuit board 150, and the another printed circuit board (e.g., the second printed circuit board 152 of FIG. 2) may be electrically connected to the printed circuit board 150 through a flexible printed circuit board. The printed circuit board 150 and the another printed circuit board may be disposed on both sides of the housing 110 of the electronic device 100, respectively. For example, the printed circuit board 150 may be disposed on a side (e.g., an upper end) of the housing 110 of the electronic device 100. The another printed circuit board may be disposed on another side (e.g., a lower end) of the housing 110 of the electronic device 100.

Electronic components (e.g., a camera, an optical sensor, a processor, or memory) disposed in an upper end of the electronic device 100 may be disposed on or connected to the printed circuit board 150. For example, at least one processor for controlling electronic components in the electronic device 100 may be disposed on the printed circuit board 150. The printed circuit board 150 may include an opening 352 (or an accommodating portion) for accommodating the speaker 310.

The opening 352 may reduce a thickness of the electronic device 100. For a thin thickness of the electronic device 100, the speaker 310 may be inserted into an opening formed in the printed circuit board 150 without being disposed on the printed circuit board 150, and the speaker 310 may be supported by a frame structure (e.g., the frame structure 140 of FIG. 2). The opening, the speaker 310 may be penetrated. The opening 352 may be referred to as an accommodating portion in terms of a portion of the speaker 310 being accommodated therein. A surface of the speaker 310 supported by the frame structure 140 may be a surface on which a diaphragm for generating an audio signal is disposed. In order to transmit an audio signal to the outside, the frame structure 140 may include an acoustic duct connected to an audio hole formed on a lateral surface of the electronic device 100. Another surface opposite to the surface of the speaker 310 may be a rear surface of the speaker 310. The rear surface of the speaker 310 may be a surface on which a resonance space for resonating an audio signal is disposed. As the speaker 310 penetrates the opening 352 and contacts the frame structure 140, the electronic device 100 may be thinner than in a case of including the speaker 310 disposed on the printed circuit board 150.

The printed circuit board 150 may include a neck portion 351 between the speaker 310 and the camera 320. The neck portion 351 may have a thinner width than other portions of the printed circuit board 150. The neck portion 351, which is a thin connection portion connecting portions of the printed circuit board 150, may be referred to as a bridge or a connection portion. A width of the printed circuit board 150 may indicate a width in an x-axis direction or a width in a y-axis direction. A width of the neck portion 351 may be the smallest among widths of the printed circuit board 150 disposed at an edge of the speaker 310. The neck portion 351 may indicate a portion having the narrowest width among portions widths of the printed circuit board 150 facing four corners of the speaker 310. The speaker 310 may be disposed adjacent to the camera 320. The neck portion 351 of the printed circuit board 150 may be disposed between the speaker 310 and the camera 320. The speaker 310 may be partially accommodated in the opening 352 of the printed circuit board, and the camera 320 may face the speaker 310 with the neck portion 351 interposed therebetween. The camera 320 may be disposed between the printed circuit board 150 and a side wall (e.g., the side wall 141 of FIG. 2) of the housing 110 of the electronic device 100. The camera 320 may be disposed adjacent to a side wall disposed in an upper portion of the electronic device 100. The speaker 310 may be disposed adjacent to the camera 320. The speaker 310 may be a receiver that transmits an audio signal received through communication with an external electronic device. The speaker 310 may obtain noise due to an influence caused by various components (e.g., an antenna, wireless communication circuitry, power amplification circuitry, or a camera) disposed on the printed circuit board 150. The antenna connected to the wireless communication circuitry may be disposed toward the side wall of the electronic device. The antenna or the wireless communication circuitry disposed adjacent to the side wall may generate a magnetic field that affects the speaker 310. Due to the noise, a quality of the audio signal transmitted through the speaker 310 may be deteriorated. In order to reduce the noise, the printed circuit board 150 may include a fill-cut portion F.

The battery 170 may be disposed adjacent to the printed circuit board 150. The battery 170 may be spaced apart from the printed circuit board 150 and disposed in a lower portion of the electronic device 100. The battery 170 may be disposed in the lower portion of the electronic device 100, and may supply power to the printed circuit board 150 or an electronic component (e.g., the speaker 310, the camera 320, the wireless communication circuitry, the power amplification circuitry, or the at least one processor) disposed on the printed circuit board 150. The battery 170 may be electrically connected to the power amplification circuitry of the wireless communication circuitry through conductive patterns in the printed circuit board 150. The wireless communication circuitry may require a large amount of current or power to transmit a radio frequency (RF) signal. The conductive patterns in the printed circuit board 150 may transmit a large amount of current to electronic components disposed on the printed circuit board 150. In the printed circuit board 150, current may flow through a portion of conductive patterns operating as a ground line. The currents may form a magnetic field that affects electronic components. The magnetic field caused by the currents may induce current into a coil of an electronic component including the coil therein, such as a camera or a speaker. By the induced current, the speaker may generate an audio signal having noise. In order to reduce or remove the noise, the printed circuit board 150 may include a neck portion having a fill-cut portion.

Referring to FIG. 4B, the printed circuit board 150 may include a plurality of non-conductive layers 401a, 401b, ..., 401n, a plurality of conductive pad 411, and a plurality of conductive patterns 421a, 421b, ..., 421n.

The plurality of non-conductive layers 401a, 401b, ..., 401n may be formed of a polymer material, and may include an insulating material. The plurality of non-conductive layers 401a, 401b, ..., 401n may provide one substrate or base material by being coupled with each other.

The conductive pad 411 may be exposed to the outside of the printed circuit board 150. The conductive pad 411 may be disposed on one outer layer among outer layers among the plurality of non-conductive layers 401a, 401b, ..., 401n. For example, the conductive pad 411 may be disposed on the first non-conductive layer 401a forming an upper layer of the printed circuit board 150.

The conductive pad 411 may be coupled with a shield can or a case for providing a resonance space of the speaker 310. For example, a case 316 may provide a resonance space for audio emitted from the speaker 310 by being disposed on the rear surface of the speaker 310. The case 316 may be disposed along a lateral surface of the speaker 310. The case 316 may be formed of a conductive material. The case 316 may be welded or joined to the conductive pad. The case 316 may shield an external noise or magnetic field by being formed of a conductive material, but it may be difficult to block an influence by conductive lines disposed below a boundary of the case. The case 316 may surround the rear surface of the speaker 310 to provide a resonance space of the speaker 310. The resonance space may be configured to emphasize a low-frequency band of the audio signal emitted from the speaker. By providing the resonance space, the case 316 may generate an audio signal of a low-frequency band. The case 316 may be coupled to the conductive pad 411. The case 316 may be sealed with the printed circuit board 150. The case 316 may reduce transmission of the audio signal generated from the speaker 310 to the outside, as a gap between the case 316 and the printed circuit board 150 is sealed. For example, the case 316 that surrounds the outside of the speaker 310 and is sealed may reduce sound leakage to the outside of the case 316. A portion of the case 316 may be disposed on a portion of the conductive pad 411 on the printed circuit board 150 along the neck portion 351. The conductive pad 411 may be formed along the opening 352 as one conductive pad. However, it is not limited thereto, and may be configured with a plurality of pads. The plurality of pads may be spaced apart from each other and disposed along the opening 352.

The printed circuit board 150 may include the conductive patterns 421a, 421b, ..., 421n disposed between the non-conductive layers 401a, 401b, ..., 401n.

The conductive patterns 421a, 421b, ..., 421n may be disposed to avoid the opening 352 and the neck portion 351. For example, the conductive patterns 421a, 421b, ..., 421n may extend along a portion of edge portions of the opening 352 excluding the neck portion 351.

The conductive patterns 421a, 421b, ..., 421n may include a conductive line transmitting a signal or power and a ground line connected to a ground portion (e.g., a conductive portion of the frame structure 140) of the electronic device 100.

The printed circuit board 150, the conductive patterns 421a, 421b, ..., 421n may be disconnected at a predetermined distance from at least a portion of the neck portion 351. For example, the printed circuit board 150 may include the fill-cut portion F in at least a portion of the neck portion 351. The fill-cut portion F may include the plurality of non-conductive layers 401a, 401b, ..., 401n and a conductive pad 411b disposed on the first non-conductive layer 401a, and may not include the conductive patterns 421a, 421b, ..., 421n. The fill-cut portion F may be a portion from which the conductive patterns 421a, 421b, ..., 421n are fully removed. The fill-cut portion F may disconnect or separate each of conductive patterns disposed on the same non-conductive layer at a predetermined distance. Not including the conductive patterns 421a, 421b, ..., 421n may indicate that the conductive patterns 421a, 421b, ..., 421n are removed from the fill-cut portion F. Not including the conductive patterns 421a, 421b, ..., 421n may indicate that the conductive patterns 421a, 421b, ..., 421n are not disposed in the fill-cut portion F.

The fill-cut portion F disposed on the neck portion 351 of the printed circuit board 150 may limit current from flowing to the neck portion 351 by disconnecting the conductive patterns 421a, 421b, ..., 421n.

By filling cut the neck portion 351 having a thin width among the edges of the speaker 310 and blocking a transmission path of the current transmitted to the neck portion 351, the magnetic field around the speaker 310 may be reduced, and thus noise transmitted to the speaker 310 may be reduced. The magnetic field transmitted to the speaker 310 may be proportional to an intensity or magnitude of current and inversely proportional to the square of a distance between the speaker 310 and a current path. Since reducing the distance between the speaker 310 and the current path may be difficult due to a narrow space inside the electronic device 100, the current flowing around the speaker 310 may be blocked by disconnecting the current path. The fill-cut portion F configured to block the current path may reduce the magnetic field around the speaker 310 by blocking the current flowing to the neck portion. The fill-cut portion F of the neck portion 351 may reduce noise transmitted to the speaker 310 by blocking the current path.

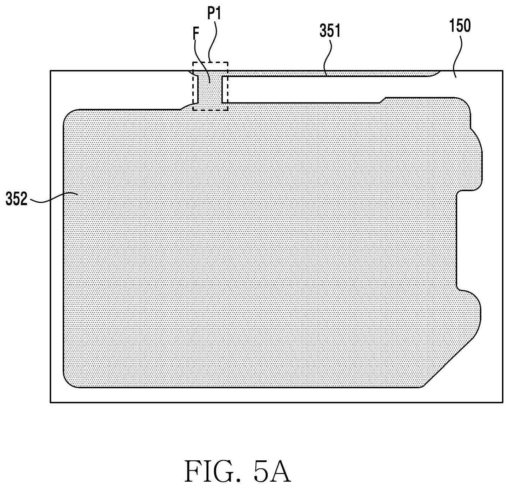

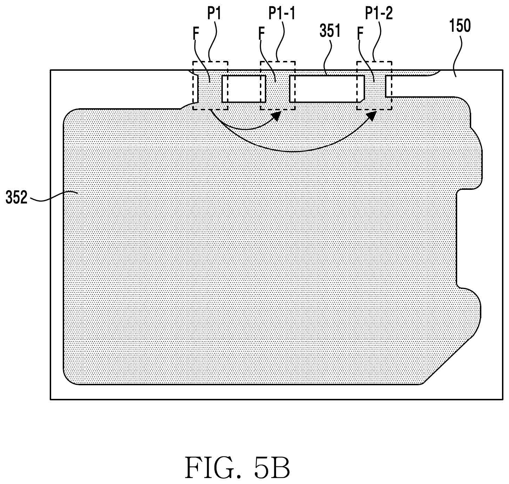

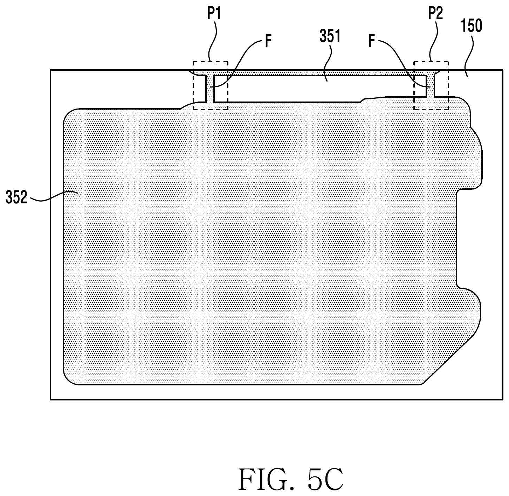

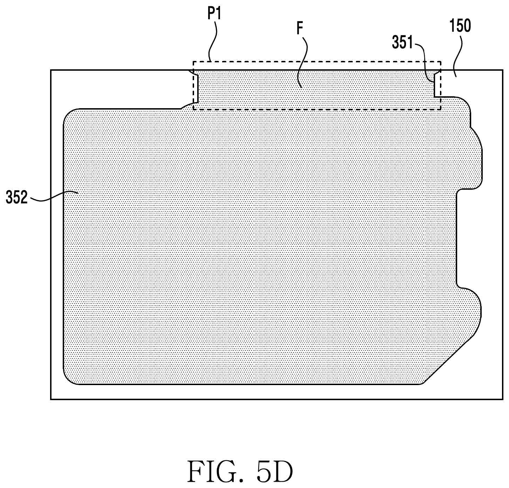

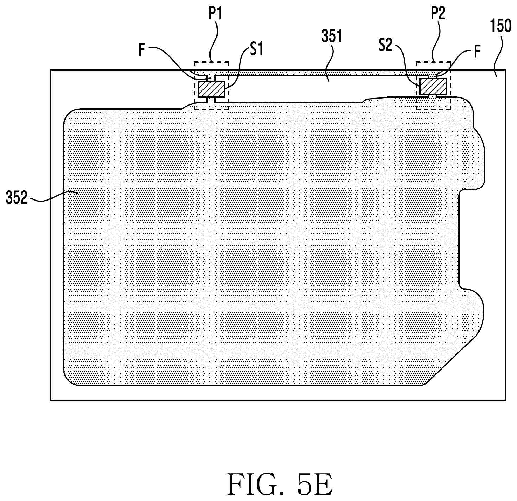

FIGS. 5A, 5B, 5C, 5D, and 5E are diagrams exemplarily illustrating disposition of a fill-cut portion of a printed circuit board.

Referring to FIG. 5A, a fill-cut portion F disposed on a neck portion 351 of a printed circuit board 150 may be disposed at a first point P1. The fill-cut portion F may indicate including non-conductive layers in the neck portion 351 and excluding conductive patterns at the neck portion 351. However, it is not limited thereto.

Referring to FIGS. 5A and 5B, it may be disposed at other points P1-1 and P1-2, which are different from the first point P1 of the neck portion 351. The neck portion 351 of the printed circuit board 150 may be a thin portion among portions of the printed circuit board 150 disposed along an edge of an opening 352 for a speaker (e.g., the speaker 310 of FIG. 3). The first point P1 may be a point corresponding to an end portion of the neck portion 351. The other points P1-1 and P1-2 may be one of inner portions of the neck portion 351. As conductive patterns 421a, 421b, ..., 421n of the neck portion 351 are removed from the fill-cut portion F, current flowing through the neck portion 351 may be reduced. In order to block the flow of current, the conductive patterns 421a, 421b, ..., 421n of the neck portion 351 may be disconnected at a predetermined distance or more. The predetermined distance or more may be a distance in which the conductive patterns 421a, 421b, ..., and 421n are difficult to form a coupling by being spaced apart from each other.

A point at which the fill-cut portion F is formed may be a point at which a width of the neck portion 351 is the narrowest, and a position is not limited.

Referring to FIG. 5C, the fill-cut portion F may be formed at a plurality of points P1 and P2 of the neck portion 351 of the printed circuit board 150. The fill-cut portion F may indicate including non-conductive layers in the neck portion 351 and excluding conductive patterns at the neck portion 351. By forming a plurality of fill-cut portions F, even when a coupling occurs in conductive patterns 421a, 421b, and 421c in some fill-cut portions F, current may be disconnected from other fill-cut portions F. The conductive patterns 421a, 421b, ..., 421n in the fill-cut portion F may be disconnected at the predetermined distance or more.

The fill-cut portion F of FIGS. 5B and 5C may be disposed to be formed at a predetermined distance or more while maintaining rigidity.

Referring to FIG. 5D, the fill-cut portion F may be formed in an entire portion P of the neck portion 351 of the printed circuit board 150. The fill-cut portion F may indicate including non-conductive layers in the neck portion 351 and excluding conductive patterns at the neck portion 351. By forming the fill-cut portion F in the entire neck portion 351, current flowing through the neck portion 351 may be reduced. In order to block the flow of current, the neck portion 351 may exclude the conductive patterns 421a, 421b, ..., 421n. In a case that rigidity is maintained even when a conductive portion of the neck portion 351 of the printed circuit board 150 is removed, the fill-cut portion F of the entire neck portion 351 of the printed circuit board 150 may be removed.

Referring to FIG. 5E, the fill-cut portion F may be formed at the plurality of points P1 and P2 of the neck portion 351 of the printed circuit board 150. A conductive pattern cut by the fill-cut portion F formed at the plurality of points P1 and P2 may be selectively connected by switches S1 and S2. For example, as the first switch S1 is disposed at the first point P1, conductive patterns connected to both ends of the first switch S1 may be selectively connected. As the second switch S2 is disposed at the second point P2, conductive patterns connected to both ends of the second switch S2 may be selectively connected. The switches S1 and S2 may be operated for tuning or impedance matching of an antenna.

FIG. 6A exemplarily illustrates a current path and a magnetic field caused by current around a speaker, which is disposed on a printed circuit board not including a fill-cut portion. FIG. 6B exemplarily illustrates a current path and a magnetic field caused by current around a speaker, which is disposed on a printed circuit board including a fill-cut portion.

Referring to FIGS. 6A and 6B, in a case that current flows through an electrical path 601, 602, or 602' formed by conductive patterns 421a, 421b, ..., 421n around a speaker 310, it indicates an effect of a magnetic field caused by the current.

The electrical path 602 flowing along a neck portion 351 allows a relatively large current to flow through the narrow neck portion 351, and a strong magnetic field may be formed. As an amount of current flowing along the electrical path 602 increases, a magnetic field may be formed around a coil inside the speaker 310 (or a receiver). By the magnetic field formed around the coil inside the speaker 310 (or the receiver), current may be induced into the coil. Due to the induced current, an unnecessary noise signal may be generated in the speaker 310 (or the receiver).

The electrical path 602' may be disconnected at a point P1 at which the fill-cut portion F formed in the neck portion 351 is formed. Current flowing to an upper portion of the speaker 310 may be blocked or reduced by the disconnected electrical path 602'. Due to the reduced current, magnitude of the magnetic field formed around the coil inside the speaker 310 may be reduced. Since the induced current formed in the coil may be decreased or absent due to the reduced magnetic field, noise generated in the speaker 310 (or the receiver) may be prevented or reduced.

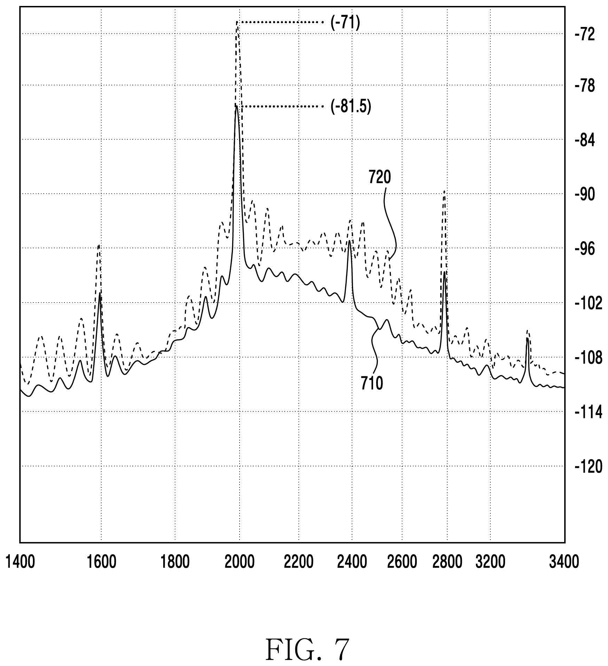

FIG. 7 exemplarily illustrates magnitude of noise transmitted to a speaker disposed on a printed circuit board including a fill-cut portion.

Referring to FIG. 7, a horizontal axis indicates a frequency of noise, a unit is Hz, and a vertical axis indicates magnitude of noise, a unit is dBm.

A graph 710 indicates magnitude of noise generated in a speaker 310 or transmitted to the speaker 310 in a case that a fill-cut portion (e.g., the fill-cut portion F of FIG. 3) is not included in a neck portion (e.g., the neck portion 351 of FIG. 3). A graph 720 indicates magnitude of noise generated in the speaker 310 or transmitted to the speaker 310 in a case that the fill-cut portion (e.g., the fill-cut portion F of FIG. 3) is included in the neck portion (e.g., the neck portion 351 of FIG. 3).

Referring to the graph 710 and the graph 720, it may be seen that the highest noise occurs in a 2000 Hz band among audible frequency bands. Referring to the graph 710, in the approximately 2000 Hz band, magnitude of noise generated in the speaker 310 may be approximately -81.5 dBm in a state that the fill-cut portion is applied. Referring to the graph 720, in the approximately 2000 Hz band, magnitude of noise generated in the speaker 310 may be approximately -71 dBm in a state that the fill-cut portion is not applied.

Since current does not flow to the neck portion 351 by conductive patterns 421a, 421b, ..., 421n removed from the fill-cut portion, an amount of current flowing around the speaker may be reduced, and thus magnitude of a magnetic field formed around the speaker may be reduced. By the reduced magnitude of the magnetic field, current flowing through a coil unit of the speaker may be decreased or removed, and thus magnitude of audio noise generated in the speaker 310 may be reduced.

The electronic device according to the above-described embodiment may improve noise generated in a speaker or a receiver. By reducing current flowing around the speaker or the receiver, magnitude of a magnetic field around the speaker or the receiver may be reduced or removed. By reducing noise generated by the magnetic field, an acoustic quality of the speaker or the receiver may be improved.

The technical problems to be achieved in this document are not limited to those described above, and other technical problems not mentioned herein will be clearly understood by those having ordinary knowledge in the art to which the present disclosure belongs, from the following description.

An electronic device (e.g., the electronic device 100 of FIG. 3) according to the above-described embodiment may include a housing (e.g., the housing 110 of FIG. 3). The electronic device may further include a camera (e.g., the camera 320 of FIG. 3) in the housing and disposed at an edge of the electronic device. The electronic device may further include a speaker (e.g., the speaker 310 of FIG. 3). The speaker may be disposed adjacent to the camera. The electronic device may further include a printed circuit board (PCB) (e.g., the printed circuit board 150 of FIG. 3). The printed circuit board may include an opening (e.g., the opening 352 of FIG. 3) in which the speaker is accommodated, and a neck portion (e.g., the neck portion 351 of FIG. 3) between the speaker and the camera. The printed circuit board may include a plurality of non-conductive layers (e.g., the non-conductive layers 401a, 401b, 401c, ..., 401n of FIG. 4B). The printed circuit board may include a conductive pad (e.g., the conductive pad 411 of FIG. 4B). The conductive pad may be disposed on one outer layer (e.g., the first non-conductive layer 401a of FIG. 4B) among outer layers of the plurality of non-conductive layers. The printed circuit board may include conductive patterns (e.g., the conductive patterns 421a, 421b, ..., 421n of FIG. 4B). The conductive patterns may be disposed between the non-conductive layers. A portion of the conductive pad may be disposed on the neck portion, and the conductive patterns may be disconnected at a predetermined distance at the neck portion.

According to the above-described embodiment, as the conductive patterns are disconnected or separated at a predetermined distance at the neck portion, current flowing around the speaker may be decreased or removed. As the current flowing around the speaker is decreased, magnitude of a magnetic field formed around the speaker may be decreased, or the magnetic field may be removed. As noise caused by the magnetic field is reduced, a quality of an audio signal of the speaker may be improved.

The conductive patterns may extend along a portion among edge portions of the opening excluding the neck portion by avoiding the opening and the neck portion.

The conductive patterns according to the above-described embodiment may transmit current or a signal by being disposed along the portion excluding the neck portion. As the flow of current around the speaker avoids the neck portion, the magnetic field formed around the speaker may be minimized. By the minimized magnetic field, a quality of an audio signal of the speaker may be improved.

The conductive patterns may include a conductive line transmitting a signal or power, and a ground line connected to a ground of the electronic device.

The conductive patterns according to the above-described embodiment may connect electronic components mounted on the printed circuit board to each other, and transmit power transmitted from a battery to the electronic component.

The electronic device may further include a case (e.g., the case 316 of FIG. 3) disposed along a lateral surface of the speaker and surrounding a rear surface of the speaker to provide a resonance space of the speaker.

The case according to the above-described embodiment may provide a resonance space for an audio signal emitted from the speaker by surrounding the rear surface of the speaker.

According to an embodiment, the case may be coupled to the conductive pad, and a space between the printed circuit board and the case may be sealed.

The case may prevent sound leakage of an audio signal emitted from the speaker as the space between the printed circuit board is sealed. As the sound leakage is prevented, magnitude of the audio signal may be maintained, and thus a quality of the audio signal may be improved.

According to an embodiment, a portion of the case may be disposed on a portion of the conductive pad on the PCB along the neck portion.

The case according to the above-described embodiment may be fixed on the printed circuit board by being coupled to the conductive pad.

According to an embodiment, a portion in which a conductive pattern in the neck portion is disconnected may be formed at a plurality of points.

The conductive pattern according to the above-described embodiment may limit current flowing to the neck portion or reduce the current flowing to the neck portion, by including the disconnected portion. The limited current or the reduced current flowing to the neck portion may reduce magnitude of a magnetic field around the speaker. Through the reduced magnitude of the magnetic field, an audio quality of the speaker may be improved.

According to an embodiment, the electronic device may further include a switch (e.g., the switch S1 or S2 of FIG. 5D) disposed at a portion in which the conductive pattern in the neck portion is disconnected to selectively connect the conductive pattern.

According to an embodiment, the conductive pattern may be excluded from an entire portion of the neck portion. In a case that rigidity is maintained even when a conductive portion of the neck portion of the printed circuit board is removed, a fill-cut portion of the entire neck portion of the printed circuit board may be removed. The neck portion according to the above-described embodiment may limit current flowing to the neck portion or reduce current flowing to the neck portion, by including a fill-cut portion from which the conductive pattern has been removed. The limited current or the reduced current flowing to the neck portion may decrease magnitude of a magnetic field around the speaker. Through the reduced magnitude of the magnetic field, an audio quality of the speaker may be improved.

According to an embodiment, the camera may be disposed between the PCB and a side wall of the electronic device. The speaker may be a receiver that transmits an audio signal received through communication with an external electronic device.

The speaker, which is a receiver, of the electronic device according to the above-described embodiment may be disposed on the printed circuit board disposed in an upper portion. The printed circuit board may be connected to wireless communication circuitry, and power amplification circuitry may be disposed thereon. As magnitude of current transmitted to the power amplification circuitry or current transmitted through the power amplification circuitry is large, noise may be transmitted to the speaker. The fill-cut portion formed at the neck portion may reduce noise around the speaker according to limiting current flowing to the neck portion by the conductive pattern is disconnected.

According to an embodiment, a width of the neck portion may be the smallest among widths of the PCB disposed at an edge of the speaker.

As the neck portion according to the above-described embodiment has the narrowest width among the widths of the printed circuit board disposed at the edge of the speaker, rigidity may be maintained even when a fill-cut portion is formed. Even when conductive portions (e.g., conductive patterns) are removed, rigidity of the printed circuit board may be maintained.

According to an embodiment, the printed circuit board may limit current supplied to the printed circuit board from flowing to the neck portion.

The printed circuit board according to the above-described embodiment may reduce magnitude of a magnetic field affecting the speaker by limiting the current transmitted to the neck portion. As the magnetic field affecting the speaker is reduced, current flowing through a coil inside the speaker is reduced, and thus noise of the speaker may be decreased.

According to an embodiment, it may further include at least one processor disposed on the PCB and operatively connected to the speaker and the camera.

According to an embodiment, the electronic device may further include wireless communication circuitry, and a battery in the housing.

The battery may be electrically connected to power amplification circuitry of the wireless communication circuitry through the conductive pattern in the PCB.

The printed circuit board according to the above-described embodiment may be connected to the wireless communication circuitry, and power amplification circuitry may be disposed thereon. As magnitude of current transmitted to the power amplification circuitry or current transmitted through the power amplification circuitry is large, noise may be transmitted to the speaker. As the conductive pattern of the fill-cut portion formed at the neck portion is disconnected, the current flowing to the neck portion is limited, and thus noise around the speaker may be reduced.

An antenna connected to the wireless communication circuitry may be disposed facing a side wall of the electronic device.

An electronic device (e.g., the electronic device 100 of FIG. 3) may further include a first electronic component (e.g., the speaker 310 of FIG. 3). The electronic device may further include a second electronic component (e.g., the camera 320 of FIG. 3). The first electronic component may be disposed adjacent to the second electronic component.

. The electronic device may further include a printed circuit board (PCB) (e.g., the printed circuit board 150 of FIG. 3). The printed circuit board may include an opening (e.g., the opening 352 of FIG. 3) in which the first electronic component is accommodated, and a neck portion (e.g., the neck portion 351 of FIG. 3) between the first electronic component and the second electronic component. The neck portion, the printed circuit board, may include a plurality of non-conductive layers (e.g., the plurality of non-conductive layers 401a, 401b, 401c, ..., 401n of FIG. 4B). The printed circuit board may include a conductive pad (e.g., the conductive pad 411 of FIG. 4B). The conductive pad may be disposed on one outer layer (e.g., the first non-conductive layer 401a of FIG. 4B) among outer layers of the plurality of non-conductive layers. The printed circuit board may include conductive patterns (e.g., the conductive patterns 421a, 421b, ..., 421n of FIG. 4B). The conductive patterns may be disposed between the non-conductive layers. A portion of the conductive pad may be disposed on the neck portion, and the conductive patterns may be disconnected at a predetermined distance at the neck portion.

According to the above-described embodiment, as the conductive patterns are disconnected or separated at a predetermined distance at the neck portion, current flowing around the speaker may be reduced or removed. As the current flowing around the speaker is decreased, magnitude of a magnetic field formed around the speaker may be decreased, or the magnetic field may be removed. As noise caused by the magnetic field is reduced, a quality of an audio signal of the speaker may be improved.

The conductive patterns may extend along a portion among edge portions of the opening excluding the neck portion by avoiding the opening and the neck portion.

The conductive patterns according to the above-described embodiment may transmit current or a signal by being disposed along the portion excluding the neck portion. As the flow of current around the speaker avoids the neck portion, a magnetic field formed around the speaker may be minimized. By the minimized magnetic field, a quality of an audio signal of the speaker may be improved.

The conductive pattern may include a conductive line transmitting a signal or power, and a ground line connected to a ground of the electronic device.

The conductive patterns according to the above-described embodiment may connect electronic components mounted on the printed circuit board to each other, and transmit power transmitted from a battery to the electronic component.

The electronic device may further include a case (e.g., the case 316 of FIG. 3) disposed along a lateral surface of the first electronic component, which is a speaker, and surrounding a rear surface of the speaker to provide a resonance space of the speaker.

The case according to the above-described embodiment may provide a resonance space for an audio signal emitted from the speaker by surrounding the rear surface of the first electronic component, which is a speaker.

According to an embodiment, the case may be coupled to the conductive pad, and a space (or gap) between the printed circuit board and the case may be sealed.

As the space between the printed circuit board is sealed, the case may prevent sound leakage of an audio signal emitted from the speaker. As the sound leakage is prevented, magnitude of the audio signal may be maintained, and thus a quality of the audio signal may be improved.

The effects that can be obtained from the present disclosure are not limited to those described above, and any other effects not mentioned herein will be clearly understood by those having ordinary knowledge in the art to which the present disclosure belongs, from the following description.

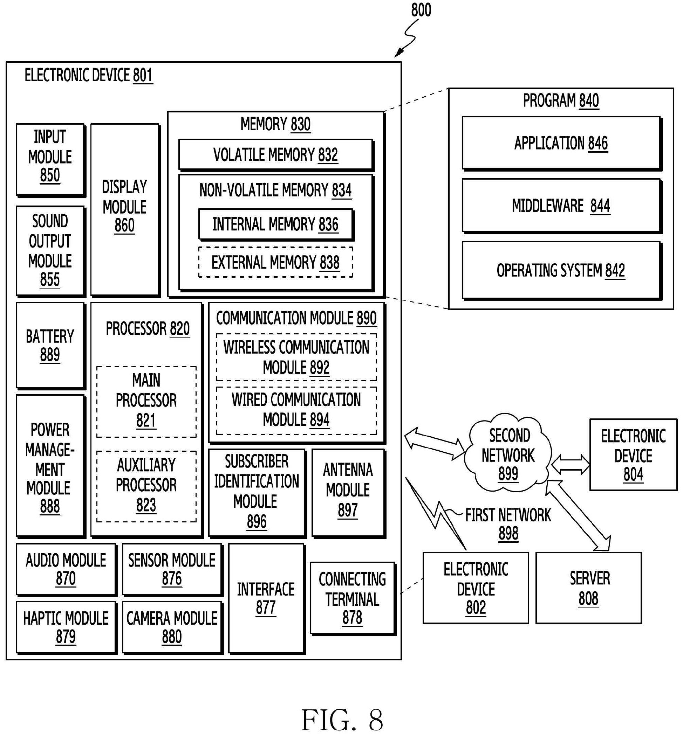

FIG. 8 is a block diagram illustrating an electronic device 801 in a network environment 800 according to various embodiments.

Referring to FIG. 8, the electronic device 801 in the network environment 800 may communicate with an electronic device 802 via a first network 898 (e.g., a short-range wireless communication network), or at least one of an electronic device 804 or a server 808 via a second network 899 (e.g., a long-range wireless communication network). According to an embodiment, the electronic device 801 may communicate with the electronic device 804 via the server 808. According to an embodiment, the electronic device 801 may include a processor 820, memory 830, an input module 850, a sound output module 855, a display module 860, an audio module 870, a sensor module 876, an interface 877, a connecting terminal 878, a haptic module 879, a camera module 880, a power management module 888, a battery 889, a communication module 890, a subscriber identification module (SIM) 896, or an antenna module 897. In some embodiments, at least one of the components (e.g., the connecting terminal 878) may be omitted from the electronic device 801, or one or more other components may be added in the electronic device 801. In some embodiments, some of the components (e.g., the sensor module 876, the camera module 880, or the antenna module 897) may be implemented as a single component (e.g., the display module 860).

The processor 820 may execute, for example, software (e.g., a program 840) to control at least one other component (e.g., a hardware or software component) of the electronic device 801 coupled with the processor 820, and may perform various data processing or computation. According to an embodiment, as at least part of the data processing or computation, the processor 820 may store a command or data received from another component (e.g., the sensor module 876 or the communication module 890) in volatile memory 832, process the command or the data stored in the volatile memory 832, and store resulting data in non-volatile memory 834. According to an embodiment, the processor 820 may include a main processor 821 (e.g., a central processing unit (CPU) or an application processor (AP)), or an auxiliary processor 823 (e.g., a graphics processing unit (GPU), a neural processing unit (NPU), an image signal processor (ISP), a sensor hub processor, or a communication processor (CP)) that is operable independently from, or in conjunction with, the main processor 821. For example, when the electronic device 801 includes the main processor 821 and the auxiliary processor 823, the auxiliary processor 823 may be adapted to consume less power than the main processor 821, or to be specific to a specified function. The auxiliary processor 823 may be implemented as separate from, or as part of the main processor 821.

The auxiliary processor 823 may control at least some of functions or states related to at least one component (e.g., the display module 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). According to an embodiment, the auxiliary processor 823 (e.g., an image signal processor or a communication processor) may be implemented as part of another component (e.g., the camera module 880 or the communication module 890) functionally related to the auxiliary processor 823. According to an embodiment, the auxiliary processor 823 (e.g., the neural processing unit) may include a hardware structure specified for artificial intelligence model processing. An artificial intelligence model may be generated by machine learning. Such learning may be performed, e.g., by the electronic device 801 where the artificial intelligence is performed or via a separate server (e.g., the server 808). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834.

The program 840 may be stored in the memory 830 as software, and may include, for example, an operating system (OS) 842, middleware 844, or an application 846.

The input module 850 may receive a command or data to be used by another component (e.g., the processor 820) of the electronic device 801, from the outside (e.g., a user) of the electronic device 801. The input module 850 may include, for example, a microphone, a mouse, a keyboard, a key (e.g., a button), or a digital pen (e.g., a stylus pen).

The sound output module 855 may output sound signals to the outside of the electronic device 801. The sound output module 855 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 860 may visually provide information to the outside (e.g., a user) of the electronic device 801. The display module 860 may include, for example, a display, a hologram device, or a projector and control circuitry to control a corresponding one of the display, hologram device, and projector. According to an embodiment, the display module 860 may include a touch sensor adapted to detect a touch, or a pressure sensor adapted to measure the intensity of force incurred by the touch.

The audio module 870 may convert a sound into an electrical signal and vice versa. According to an embodiment, the audio module 870 may obtain the sound via the input module 850, or output the sound via the sound output module 855 or a headphone of an external electronic device (e.g., an electronic device 802) directly (e.g., wiredly) or wirelessly coupled with the electronic device 801.

The sensor module 876 may detect an operational state (e.g., power or temperature) of the electronic device 801 or an environmental state (e.g., a state of a user) external to the electronic device 801, and then generate an electrical signal or data value corresponding to the detected state. According to an embodiment, the sensor module 876 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device (e.g., the electronic device 802) directly (e.g., wiredly) or wirelessly. According to an embodiment, the interface 877 may include, for example, a high definition multimedia interface (HDMI), a universal serial bus (USB) interface, a secure digital (SD) card interface, or an audio interface.

A connecting terminal 878 may include a connector via which the electronic device 801 may be physically connected with the external electronic device (e.g., the electronic device 802). According to an embodiment, the connecting terminal 878 may include, for example, an HDMI connector, a USB connector, an SD card connector, or an audio connector (e.g., a headphone connector).

The haptic module 879 may convert an electrical signal into a mechanical stimulus (e.g., a vibration or a movement) or electrical stimulus which may be recognized by a user via his tactile sensation or kinesthetic sensation. According to an embodiment, the haptic module 879 may include, for example, a motor, a piezoelectric element, or an electric stimulator.

The camera module 880 may capture a still image or moving images. According to an embodiment, the camera module 880 may include one or more lenses, image sensors, image signal processors, or flashes.

The power management module 888 may manage power supplied to the electronic device 801. According to an embodiment, the power management module 888 may be implemented as at least part of, for example, a power management integrated circuit (PMIC).

The battery 889 may supply power to at least one component of the electronic device 801. According to an embodiment, the battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the application processor (AP)) and supports a direct (e.g., wired) communication or a wireless communication. According to an embodiment, the communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device via the first network 898 (e.g., a short-range communication network, such as Bluetooth^{™}, wireless-fidelity (Wi-Fi) direct, or infrared data association (IrDA)) or the second network 899 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 892 may identify and authenticate the electronic device 801 in a communication network, such as the first network 898 or the second network 899, using subscriber information (e.g., international mobile subscriber identity (IMSI)) stored in the subscriber identification module 896.

The wireless communication module 892 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 892 may support a high-frequency band (e.g., the mmWave band) to achieve, e.g., a high data transmission rate. The wireless communication module 892 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 892 may support various requirements specified in the electronic device 801, an external electronic device (e.g., the electronic device 804), or a network system (e.g., the second network 899). According to an embodiment, the wireless communication module 892 may support a peak data rate (e.g., 20Gbps or more) for implementing eMBB, loss coverage (e.g., 864dB or less) for implementing mMTC, or U-plane latency (e.g., 0.5ms or less for each of downlink (DL) and uplink (UL), or a round trip of 8ms or less) for implementing URLLC.

The antenna module 897 may transmit or receive a signal or power to or from the outside (e.g., the external electronic device) of the electronic device 801. According to an embodiment, the antenna module 897 may include an antenna including a radiating element composed of a conductive material or a conductive pattern formed in or on a substrate (e.g., a printed circuit board (PCB)). According to an embodiment, the antenna module 897 may include a plurality of antennas (e.g., array antennas). In such a case, at least one antenna appropriate for a communication scheme used in the communication network, such as the first network 898 or the second network 899, may be selected, for example, by the communication module 890 (e.g., the wireless communication module 892) from the plurality of antennas. The signal or the power may then be transmitted or received between the communication module 890 and the external electronic device via the selected at least one antenna. According to an embodiment, another component (e.g., a radio frequency integrated circuit (RFIC)) other than the radiating element may be additionally formed as part of the antenna module 897.

According to various embodiments, the antenna module 897 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 801 and the external electronic device 804 via the server 808 coupled with the second network 899. Each of the electronic devices 802 or 804 may be a device of a same type as, or a different type, from the electronic device 801. According to an embodiment, all or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 801. The electronic device 801 may provide the outcome, with or without further processing of the outcome, as at least part of a reply to the request. To that end, a cloud computing, distributed computing, mobile edge computing (MEC), or client-server computing technology may be used, for example. The electronic device 801 may provide ultra low-latency services using, e.g., distributed computing or mobile edge computing. In another embodiment, the external electronic device 804 may include an internet-of-things (IoT) device. The server 808 may be an intelligent server using machine learning and/or a neural network. According to an embodiment, the external electronic device 804 or the server 808 may be included in the second network 899. The electronic device 801 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 840) including one or more instructions that are stored in a storage medium (e.g., internal memory 836 or external memory 838) that is readable by a machine (e.g., the electronic device 801). For example, a processor (e.g., the processor 820) of the machine (e.g., the electronic device 801) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing;
a camera disposed in the housing and disposed at an edge of the electronic device;
a speaker disposed adjacent to the camera; and
a printed circuit board (PCB) comprising an opening in which the speaker is accommodated, the PCB including a neck portion between the speaker and the camera,
wherein the PCB includes:
a plurality of non-conductive layers,
a conductive pad disposed on one outer layer among outer layers of the plurality of non-conductive layers, and
conductive patterns disposed between the plurality of non-conductive layers,
wherein a portion of the conductive pad is disposed on the neck portion, and
wherein the conductive patterns are disconnected at a predetermined distance at the neck portion of the PCB.

2. The electronic device of claim 1, wherein the conductive patterns extend along edge portions of the opening excluding the neck portion by avoiding the opening and the neck portion.

3. The electronic device of any one of claims of 1 or 2, wherein the conductive patterns include:
a conductive line configured to transmit a signal or power, and
a ground line connected to a ground of the electronic device.

4. The electronic device of any one of claims of 1 to 3, further comprising a case disposed along a lateral surface of the speaker and surrounding a rear surface of the speaker to provide a resonance space of the speaker.

5. The electronic device of claim 4, wherein the case is coupled to the conductive pad, and
wherein a space between the PCB and the case is sealed.

6. The electronic device of claim 4, wherein a portion of the case is disposed on a portion of the conductive pad on the PCB along the neck portion.

7. The electronic device of any one of claims 1 to 6, wherein portions in which conductive patterns in the neck portion are disconnected are formed at a plurality of points.

8. The electronic device of any one of claims 1 to 7, further comprising a switch disposed at portions in which the conductive patterns in the neck portion are disconnected to selectively connect the conductive patterns.

9. The electronic device of any one of claims 1 to 8, wherein the conductive patterns are not disposed on an entire portion of the neck portion.

10. The electronic device of any one of claims 1 to 9, wherein the camera is disposed between the PCB and a side wall of the electronic device, and
wherein the speaker is a receiver configured to transmit an audio signal received through communication with an external electronic device.

11. The electronic device of any one of claims 1 to 10, wherein a width of the neck portion is the smallest among widths of the PCB disposed at an edge of the speaker.

12. The electronic device of any one of claims 1 to 11, wherein the PCB limits current supplied to the PCB from flowing to the neck portion.

13. The electronic device of any one of claims 1 to 12, further comprising at least one processor disposed on the PCB and operatively connected to the speaker and the camera.

14. The electronic device of any one of claims 1 to 13, further comprising:
wireless communication circuitry, and
a battery disposed in the housing,
wherein the battery is electrically connected to power amplification circuitry of the wireless communication circuitry through the conductive patterns in the PCB.

15. The electronic device of any one of claims 1 to 14, wherein an antenna connected to the wireless communication circuitry is disposed facing a side wall of the electronic device.
